# EUROPEAN PATENT APPLICATION

(11) **EP 2 224 474 A2**
(43) Date of publication of application: **01.09.2010**
(21) Application number: 10154913.7
(22) Date of filing: 26.02.2010
(51) Int. Cl.: H01L 21/66

(54) **Test structure for integrated circuits**

(30) Priority: 26.02.2009 GB 0903286
(71) Applicant: Melexis Tessenderlo NV, 3980 Tessenderlo (BE)
(72) Inventor: De Winter, Rudi, 3980 Tessenderio (BE); Betts, William, Robert, 3980 Tessenderio (BE)
(74) Representative: Wilson Gunn

(57) **Abstract**

A test insert 100 for an integrated circuit according to the present invention comprises access contacts 101, 103 and 104 and an electrical path 110. Furthermore, there may be additional access contacts and a plurality of different electrical paths. The electrical path 110 is comprised of a plurality of tracks 111, each track provided at a single layer of the integrated circuit and connected to the other tracks 111 by interconnecting vias 102. The vias 102 provide interlayer contacts and thus allow the tracks 111 to be connected into a single electrical track 110. In one embodiment, an access contact 104 is connected to ground; another contact 101 is connected to a reference voltage: and connected to various points in the electrical path 110 are transistor-resistor pairs 123. 124, 125. The transistor-resistor pairs 123, 124, 125 are in connected between earth and a third access contact 103. If the electrical path is intact at the track 111 connected to a transistor-resistor pair 123, 124, 125, a current can flow between contact 103 and the respective earth of the transistor-resistor pair 123, 124, 125. By analysing the current drawn from contact 103 it can be deduced whether the path 110 is operational as a whole and if not, how far along the path 110 a fault lies. This can therefore isolate a particular interconnection between layers or a particular layer as being faulty.

## Description

The present invention relates to the testing of integrated circuits at the manufacture stage and in particular to a test insert provided for this purpose

In modern semiconductor processes a plurality of mtegrated circuits are formed simultaneously on a single wafer Each integrated circuit may contain millions of circuit elements manufactured with many masks and layers. Correspondingly, each integrated circuit may comprise millions of connections or contacts between the various layers. In recent years there has been an increase in the number of active elements in a typical integrated circuit This has lead to a corresponding increase in the number of interconnections, or contacts, between the various layers that go to make up the integrated circuit.

In normal practise, on each semiconductor wafer in addition to the integrated circuits, one or more test insets are formed The test inserts are formed in place of an integrated circuit for use as process control and quality monitoring aids. The test inserts contain a number of representative circuit and interconnect elements connected to one or more access contacts to allow their individual and collective performance to be measured or determined. Since each such test insert occupies a potential integrated circuit location they reduce the number of integrated circuits that can be formed on a single wafer. This inefficiency has the effect of increasing the unit cost per integrated circuit.

As an alternative, in some processes a small test insert array comprising only a few transistors is provided for each individual integrated circuit. Use of a small test insert array using only transistors is not always a reliable test of the wafer process integrity, particularly if a number of more complex components are provided in the integrated circuits. Accordingly this can be seen as a waste of space and an unnecessary expense.

It is therefore an object of the present invention to provide a test insert that at least partly overcomes or alleviates the above problems.

According to a first aspect of the present invention there is provided a test insert for an integrated circuit of the type formed on a wafer and having one or more interconnected layers, the test insert comprising a plurality of interlayer contacts providing a plurality of conducting paths between the layers of the integrated circuit; one or more access contacts for providing connections between the plurality of connecting paths and external circuitry so as to allow one or more signals to be conducted through one or more of the conducting paths to provide an indication ot the quality of the manufacturing process, the interlayer contacts and the access contacts both being provided at or within the boundary area of the integrated circuit.

Such a test insert is suitable to enable the quality of interlayer contacts to be determined at each integrated circuit within a wafer. This enables statistical information relating to the likely quality and reliability of circuit elements to be gathered across all sites on a wafer, thus improving quality control and reliability.

According to a second aspect of the present invention there is provided an integrated circuit incorporating a test insert according to the first aspect of the present invention.

The integrated circuit of the second aspect of the present invention may incorporate any or all features of the test insert of the first aspect of the present invention as desired or as appropriate.

According to a third aspect of the present invention there is provided a method of testing an integrate circuit in accordance with the second aspect of the present invention, the method comprising the steps of connecting one or more items of external circuitry to the access contacts, applying electrical signals to the access contacts; monitoring the signal generated in response and thereby determining the likely quality and reliability of circuit elements in the integrated circuit.

The method of the third aspect of the present invention may incorporate any or all features of the test insert of the first aspect of the present invention or the integrated circuit of the second aspect of the present invention as desired or as appropriate.

According to a fourth aspect of the present invention there is provided a method of manufacturing an integrated circuit, the method comprising the steps of providing a semiconductor wafer, forming an array of integrated circuits on said wafer; forming a test insert according to the first aspect of the present invention at or within the boundary area of each integrated circuit; and testing each integrated circuit in accordance with the method of the third aspect of the invention.

The method of the fourth aspect of the present invention may incorporate any or all features of the test insert ot the first aspect of the present invention, the integrated circuit of the second aspect of the present invention or the method of the third d aspect of the present invention as desired or as appropriate.

The interlayer contacts may be vias. Preferably the numbers ot interlayer contacts of each type in the test insert are in proportion to the numbers of interlayer contacts of each type in the integrated circuit itself.

Preferably interlayer contacts of each type are connected in series to form short electrical paths. An access contact may be provided at each end of the short electrical path There may be more than one such short electrical path One or more such short electrical paths may be connected in series to form one or more longer electrical paths. In such cases, the access contacts at each end of the short electrical paths may enable intermediate measurements to be taken

The access contacts and/or the interlayer contacts may be arranged to present a visual pattern upon the surface of the wafer. Preferable, the layout may be adapted such that the presented visual pattern is distinctive or unique for a particular integrated circuits or for a particular type of integrated circuit. Preferably, the presented visual pattern is adapted to resemble or represent one or more alphanumeric characters. The alphanumeric characters may be related to the integrated circuit part or identity number

In a further embodiment of the invention additional circuitry is also provided. The additional circuitry may be connected to said electrical paths directly or indirectly. Direct connections may be achieved via said access contacts. The additional circuitry may be arranged to generate electrical signals indicative of the conduction performance of said interface contacts in said electrical paths. The additional circuitry may comprise a plurality of transistor-resistor pairs, each transistor-resistor pair connected to a different point within an electrical path. This can provide an indication of where an electrical path a fault is located

In order that the invention is more clearly understood one embodiment will now be described further below, by way of example only and with reference to the accompanying drawings, in which:
- Figure 1: is a simplified schematic view of an electrical path in a test insert for a multilayer integrated circuit according to the present invention;
- Figure 2: is a schematic cross-sectional view of how electrical paths may be arranged in a test insert for a multilayer integrated circuit according to the present Invention, and
- Figure 3: is a simplified schematic view which shows schematically how a number of different electrical paths may be connected in series in a test insert for a multilayer integrated circuit according to the present invention.

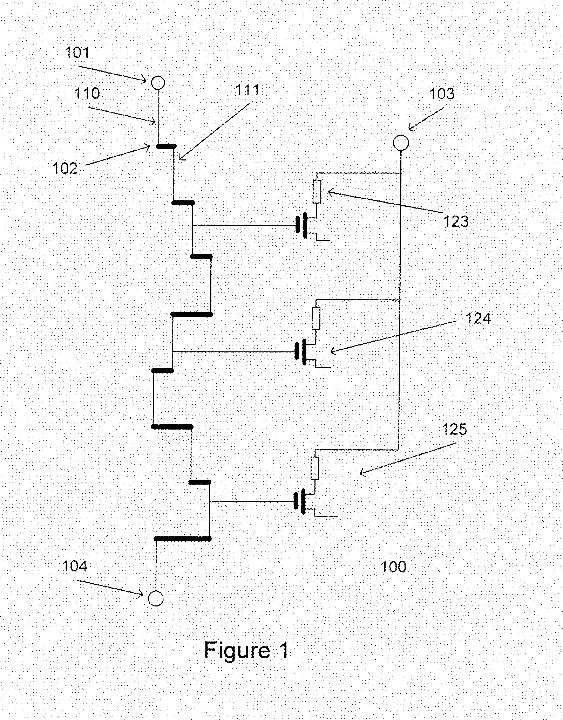

Turning now to figure 1, this is a simplified schematic view of a test insert 100 for a multilayer integrated circuit (not shown) The test insert 100 is provided at or within the boundary area of the integrated circuit The test insert 100 comprise access contacts 101, 103 and 104 and an electrical path 110. In more complex embodiments, there may be additional access contacts and a plurality of different electrical paths In some such embodiments, it may be possible to connect one or more electrical paths via particular access contacts.

The electrical path 110 is composed of a plurality of tracks 111, each track provided at a single layer of the integrated circuit and connected to the other tracks 111 by interconnecting vias 102. The vias 102 provide interlayer contacts and thus allow the tracks 111 to be connected into a single electrical track 110.

The number of tracks 111 in particular layers and the number of vias 102 in the path 110 is ideally in proportion to the numbers of such within the integrated circuit. This is so that testing the interface 100 should provide useful information in relation to the likely reliability of elements within the integrated circuit.

In the example shown, access contact 104 is connected to ground and contact 101 is connected to a reference voltage Connected to various points in the electrical path 110 are transistor-resistor pairs 123, 124, 125. The transistor-resistor pairs 123, 124, 125 are in connected between earth and access contact 103. If the electrical path is intact at the track 111 connected to a tranststor-reststor pair 123, 124, 125. a current can flow between contact 103 and the respective earth of the transistor-resistor pair 123, 124, 125 By analysing the current draw from contact 103 it can he deduced whether the path 110 is operational as a whole and, if not, how far along the path 110 a fault lies. This can therefore isolate a particular interconnection between layers or a particular layer as being faulty

In an alternative arrangement, 101 and 104 could be connected to the internal reference voltage and ground pins of the integrate circuit.

In practice, such a test insert 100 will be provide for each integrated circuit formed on a wafer (not shown). If a threshold number of the test inserts 100 show the same fault, the whole wafer may be determined to be faulty at an early stage of processing, thereby saving costs in separation and additional processing of potentially faulty individual integrated circuits.

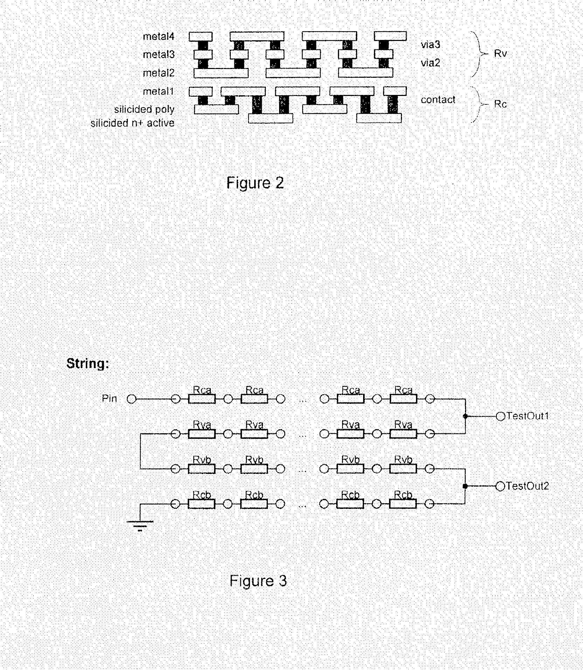

Turning now to figure 2, this shows a schematic cross-sectional view of how such paths 110 may be arranged. In the example shown the integrated circuit has four metal layers, a silicided poly layer and a silicided n+ active layer Here two separate paths Rv and Rc are shown Kv comprises tracks within and vias between metal layers 2, 3 and 4 whilst Rc comprises tracks within and vias between metal layer I and the silicided poly and n+ active layers. Testing on path Rv can thus provide an indication of the reliability of metal layers 1-3 and the vias therebetween whilst testing on path Rc can thus provide an indication of the reliability of metal layer 1, the silicided poly layer and the n+ active layer as well as the vias between metal layer 1 and the silicided poly and n+ active layers. It is of course possible that paths providing different connections between layers may alternatively be provided, if similar interconnections are provided in the integrated circuit Access contacts may be provided in any suitable layer of the interface.

Turning now to figure 3, this shows schematically how a number of different electrical paths may be connected in series to form the test insert 100. In the present case, the paths are connected between a reference voltage (Pin) and a ground connection. At intermediate points within the paths, access contacts (TestOut1, TestOut2) may be provided These can be connected to the electrical paths directly or through a transistor-resistor pair such as 123, 124 or 125 in figure 1 By measuring the voltage and or current at each access contact, an indication of the quality of each electrical path can be obtained, thus enabling a potentially faulty path to be identified.

In the present case, between Pin and TestOut1 there is a path comprising a plurality of connections Rca along and between metal layer 1 and the silicided poly and n⁺ active layers; between TestOut1 and TestOut2 is a path comprising a plurality of connections Rva, Rvb along and between metal layers 1-3; and between TestOut2 and ground is a path comprising a plurality of connections Rcb along and between metal layer I and the silicided poly and n+ active layers. It is possible to arrange multiple such paths in any suitable combinations for testing the particular integrated circuit of interest.

A further possibility is that the interface can be arranged to provide a particular visual pattern on the surface of the wafer Typically this might primarily be down to the pattern of tracks and contacts provided in the uppermost metal layer, for instance in the example of figure 2, metal layer 4 The pattern can be adapted to provide a recognisable alphanumeric identifier for the particular type of integrated circuit under manufacture. This can aid testes in identifying the integrated circuit correctly.

The access contacts may be provided in standard locations and/or spacings for each integrate circuit This can allow a universal test head to be used to test may different types of integrated circuit Alternatively, the access contacts may be provided at different locations and/or spacings for different types of integrated circuit This may require a different test head for each different type of integrated circuit. Since different circuits have different combinations of elements, this may be the case even where the access contacts are provided in standard locations and/or spacings.

If the interface provides a visual pattern, this can be also be provided on the test head to enable a tester to readily tell whether a correct test head is being used

It is or course to be under stood that the invention is not to be restricted to the details of the above embodiments which are described by way of example only.

## Claims

1. A test insert for an integrated circuit of the type formed on a wafer and having one or more interconnected layers, the test insert comprising: a plurality of interlayer contacts providing a plurality of conducting paths between the layers of the integrated circuit, one or more access contacts for providing connections between the plurality of connecting paths and external circuitry so as to allow one or more signals to he conducted through one or more of the conducting paths to provide an indication of the quality of the manufacturing process, the interlayer contacts and the access contacts both being provided at or within the boundary area of the integrated circuit.

2. A test insert as claimed in claim 1 wherein the interlayer contacts are vias.

3. A test insert as claimed in claim 1 or claim 2 wherein the numbers of interlayer contacts of each type in the test insert are in proportion to the numbers of interlayer contacts of each type in the integrated circuit itself

4. A test inset as claimed in any preceding claim wherein interlayer contacts of each type are connected in series to form short electrical paths.

5. A test insert as claimed in any preceding claim wherein as access contact is provided at each end of the short electrical path

6. A test insert as claimed in claim 5 wherein the test insert comprises more than one such short electrical path

7. A test insert as claimed in claim 5 or claim 6 wherein one or more such short electrical paths are connected in series to form one or more longer electrical paths

8. A test insert as claimed in any one of claims 5 to 7 wherein the access contacts at each end of the short electrical paths enable intermediate measurements to be taken

9. A test insert as claimed in any preceding claim wherein the access contacts and/or the interlayer contacts are arranged to present a visual pattern upon the surface of the wafer.

10. A test insert as claimed in claim 9 wherein the layout is adapted such that the presented visual pattern is distinctive or unique for a particular integrated circuit or for a particular type of integrated circuit

11. A test insert as claimed in claim 9 or claim 10 wherein the presented visual pattern is adapted to resemble or represent one or more alphanumeric characters.

12. A test insert as claimed in claim 11 wherein the alphanumeric characters are related to the integrated circuit part or identity number.

13. A test insert as claimed in any preceding claim wherein additional circuitry is also provided and the additional circuitry is connected to said electrical paths directly or indirectly

14. A test insert as claimed claim 13 wherein the additional circuitry is arranged to generate electrical signals indicative of the conduction performance of said interface contacts in said electrical paths

15. A test insert as claimed in claim 13 wherein the additional circuitry comprise a plurality of transistor-resistor pairs, each transistor-resistor pair connected to a different point within an electrical path.

16. An integrated circuit of the type formed on a wafer and having one or more interconnected layers and incorporating a test insert as claimed in any one of claims 1 to 15.

17. A method of testing an integrated circuit as claimed in claim 16, the method comprising the steps of connecting one or more items of external circuitry to the access contacts, applying electrical signals to the access contacts, monitoring the signal generated in response and thereby determining the likely quality and reliability of circuit elements in the integrated circuit.

18. A method of manufacturing an integrated circuit of the type formed on a wafer and having one or more interconnected layers, the method comprising the steps of: providing a semiconductor wafer; forming an array of integrated circuits on said wafer; forming a test insert as claimed in any one of claims 1 to 15 for each of one of more of the integrated circuits at or within the boundary area of each integrated circuit; and testing each integrated circuit using the method as claimed in claim 17.
